(19) Europäisches Patentamt / European Patent Office / Office européen des brevets

(11) **EP 1 307 885 B1**

(12) **EUROPÄISCHE PATENTSCHRIFT**

(45) Veröffentlichungstag und Bekanntmachung des Hinweises auf die Patenterteilung:
**10.12.2008 Patentblatt 2008/50**

(21) Anmeldenummer: **01956567.0**

(22) Anmeldetag: **26.07.2001**

(51) Int Cl.:
**G11C 7/06** (2006.01)

(86) Internationale Anmeldenummer:
**PCT/EP2001/008667**

(87) Internationale Veröffentlichungsnummer:
**WO 2002/013198 (14.02.2002 Gazette 2002/07)**

(54) **HOCHGESCHWINDIGKEITS-LESE-STROMVERSTÄRKER**

HIGH SPEED SENSE AMPLIFIER

AMPLIFICATEUR DE DETECTION A VITESSE ELEVEE

(84) Benannte Vertragsstaaten:
**DE FR GB IT**

(30) Priorität: **07.08.2000 DE 10038383**

(43) Veröffentlichungstag der Anmeldung:
**07.05.2003 Patentblatt 2003/19**

(73) Patentinhaber: **Infineon Technologies AG**
**81669 München (DE)**

(72) Erfinder:
 • **EKKART, Martin**
 **80689 München (DE)**

 • **MOYAL, Michael**
 **81735 München (DE)**
 • **ETTORE, Riccio**
 **81735 München (DE)**
 • **SCHULZ, Dirk**
 **80638 München (DE)**

(74) Vertreter: **Charles, Glyndwr**
 **Reinhard, Skuhra, Weise & Partner GbR**
 **Patent- und Rechtsanwälte**
 **Friedrichstrasse 31**
 **80801 München (DE)**

(56) Entgegenhaltungen:
**US-A- 5 386 158**

EP 1 307 885 B1

**Beschreibung**

Die Erfindung betrifft einen Hochgeschwindigkeits-Lese-Stromverstärker mit niedrigem Leistungsverbrauch für eine Speicherzelle.

Halbleiterspeicher sind binäre Datenspeicher, bei denen die einzelnen Speicherzellen SZ matrixförmig angeordnet sind und aus Halbleiterbauelementen, insbesondere Transistoren, bestehen. Die Speicherzellen SZ sind dabei an Wortleitungen WL und senkrecht dazu verlaufenden Bitleitungen BL angeschlossen. Die Matrix enthält n*m Speicherzellen. Die Adressierung, d. h. die Auswahl einer Speicherzelle SZ bzw. eines Speicherwortes erfolgt durch Aktivierung der Wortleitungen WL. Die Adressierung wird dabei durch einen Adressendekoder vorgenommen, der bei n externen Adressleitungen intern $2^n$ Auswahlsignale zur Wortleitungs- und Bitleitungsauswahl erzeugt. Die in den Speicherzellen SZ enthaltenen Dateninformationen werden über einen Leseverstärker ausgelesen.

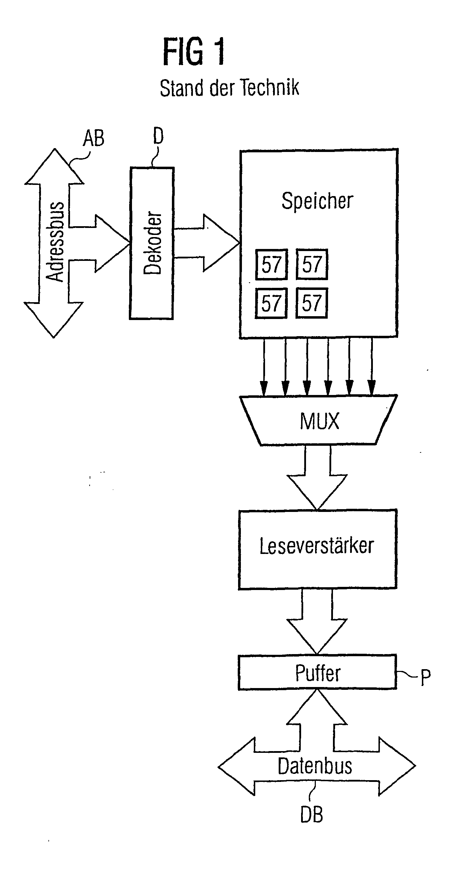

Figur 1 zeigt schematisch den Aufbau einer Halbleiterspeicheranordnung. Der Adressendekoder D liegt an einem Adressenbus AB an und dekodiert das an dem Adressenbus AB anliegende Adressierungssignal zur Auswahl von Speicherzellen SZ innerhalb des Halbleiterspeichers. Die in den Speicherzellen SZ enthaltenen ausgelesenen Daten gelangen über Speichersignalleitungen zu einem Multiplexer MUX, der ausgangsseitig an dem Leseverstärker angeschlossen ist. Der Leseverstärker verstärkt das erhaltene Speichersignal und gibt es über einen Ausgangspuffer P an einen Datenbus DB ab.

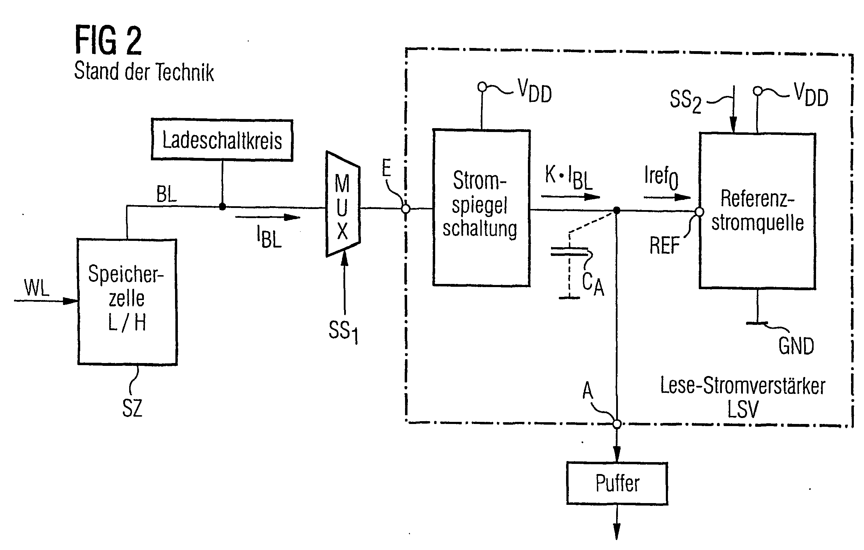

Figur 2 zeigt schematisch einen Teil eines Lese-Stromverstärkers zum Auslesen und Verstärken des in einer Speicherzelle SZ enthaltenen Dateninhalts nach dem Stand der Technik.

Die Speicherzelle SZ enthält eine Daten-Bitinformation, wobei sich die Speicherzelle SZ in einem logisch niedrigen Zustand L(low) oder einem logisch hohem Zustand H(high) befindet. Bei der Speicherzelle SZ kann es sich um eine RAM-Speicherzelle oder um eine ROM-Speicherzelle handeln. Die Speicherzelle SZ wird über einen von dem Dekoder D wegführende Wortleitung WL adressiert und gibt den in ihr enthaltenen Dateninhalt über die Bitleitung BL ab. Dabei fließt ein Speichersignalstrom $I_{BL}$ über die Speichersignalleitung bzw. Bitleitung BL zu dem Multiplexer MUX. Der Speichersignalstrom $I_{BL}$ ist null, wenn die Speicherzelle SZ sich in einem logisch niedrigen Zustand L befindet. Falls die Speicherzelle SZ sich in einem logisch hohem Zustand H befindet, fließt ein vorgegebener Speichersignalstrom $I_{BL}$. Die Bitleitung BL weist eine Leitungskapazität auf und ist über einen Ladeschaltkreis, der bspw. aus einem getakteten MOSFET-Transistor besteht, vor bzw. wiederaufladbar. Der Multiplexer MUX wird in Abhängigkeit eines Selektionssignals SS1 gesteuert und schaltet die Speichersignalleitung BL an den Eingang E des Lese-Stromverstärkers LSV durch.

Der Lese-Stromverstärker LSV enthält eine Stromspiegelschaltung, die mit einer Versorgungsspannung $V_{DD}$ versorgt wird. Die Stromspiegelschaltung liegt ausgangsseitig an einem Knoten an, der mit dem Ausgang A des Lese-Stromverstärkers LSV nach dem Stand der Technik verbunden ist. Die Stromspiegelschaltung verstärkt den über den Eingang E empfangenen Speichersignalstrom $I_{BL}$ mit einem konstanten Faktor K und gibt den verstärkten Strom $K \cdot I_{BL}$ an dem Ausgang A des Lese-Stromverstärkers LSV ab. An dem mit dem Ausgang A verbundenen Stromknoten ist ferner eine Referenzstromquelle an einem Referenzstromquellenanschluß REF angeschlossen. Die Referenzstromquelle nach dem Stand der Technik ist ebenfalls an die Versorgungsspannung $V_{DD}$ angeschlossen und ist über ein Selektionssignal SS2 selektierbar. Der Summenstromknoten besitzt eine intrinsische Kapazität $C_A$.

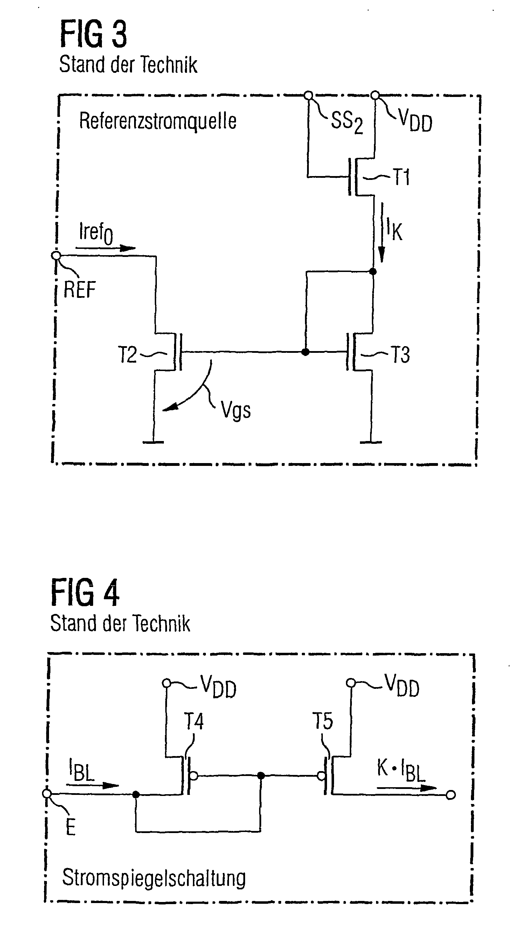

Figur 3 zeigt die in Figur 2 dargestellte Referenzstromquelle nach dem Stand der Technik. Die Referenzstromquelle enthält mehrere N-MOSFET-Transistoren T1, T2, T3. Der N-MOSFET-Transistor T1 der Referenzstromquelle erzeugt in Abhängigkeit des Selektionssignals SS2 einen konstanten Strom. Ist das Selektionssignal SS2 logisch 0, ist der Konstantstrom $I_K$ des MOSFET-Transistors T1 null. Ist umgekehrt das Selektionssignal SS2 angeschaltet, fließt durch den N-MOSFET-Transistor T1 ein konstanter Strom $I_{K\emptyset}$ mit bestimmter konstanter Stromhöhe. Es gilt:

$$
\begin{aligned}
I_K &= 0 & \text{wenn} && SS2 &= 1 \qquad\qquad (1)\\
I_K &= I_{K\emptyset} & \text{wenn} && SS2 &= \emptyset
\end{aligned}
$$

Die Referenzstromquelle nach dem Stand der Technik enthält ferner eine aus den beiden N-MOSFET-Transistoren T2, T3 bestehenden Stromspiegelschaltung, wobei die beiden Gate-Anschlüsse der beiden N-MOSFET-Transistoren T2, T3 miteinander verbunden sind und eine direkte Verbindung mit dem Source-Anschluß des N-MOSFET-Transistors T1 besitzen. Der Konstantstrom $I_{K\emptyset}$ wird durch die Stromspiegelschaltung T2, T3 gespiegelt, wobei die Stromverstärkung durch das Stromkanal Breiten/Längenverhältnis W/L der beiden Transistoren T2, T3 bestimmt wird.

Der N-MOSFET T2 der Stromspiegelschaltung weist einen Source-Anschluß auf, der mit Masse verbunden ist, sowie einen Drain-Anschluß, der an dem Referenzstromanschluss REF anliegt. Die Stromspiegelschaltung T2, T3 erzeugt an dem Referenzstromanschluß REF einen konstanten Referenzstrom $I_{REF\emptyset}$ wobei gilt:

$$I_{REF\emptyset} = \frac{\mu \; C_{ox} \; W/L}{2} \, (V_{GS} \; - \; V_T)^2 \qquad\qquad (2)$$

wobei :

W/L das Kanalweiten/Längenverhältnis des Transistors T2,
$C_{OX}$ die Kapazität des Dielektrikums,
$V_T$ die Schwellenspannung des Transistors T2,
$V_{GS}$ die Gate/Source-Spannung des Transistors T2 ist.

Da die Spannung $V_{gs}$ zwischen dem Gate und dem Source des Transistors T2 konstant ist und auch die übrigen Größen vorgegeben sind, ist der durch die Referenzstromquelle erzeugte Referenzstrom $I_{REF0}$ konstant.

Figur 4 zeigt die in dem Lese-Stromverstärker enthaltene Stromspiegelschaltung nach dem Stand der Technik. Die Stromspiegelschaltung enthält zwei P-MOSFET T4, T5 deren Gate-Anschlüsse miteinander verbunden sind und an dem Eingang E der Stromspiegelschaltung anliegen. Die beiden Drain-Anschlüsse der beiden P-MOSFET T4, T5 liegen an dem Versorgungsspannungspotential $V_{DD}$ an. Der Source-Anschluß des ersten P-MOSFET T4 ist ebenfalls mit dem Signaleingang E der Stromspiegelschaltung verbunden und erhält den Speichersignalstrom $I_{BL}$. Die Kanalweiten/Längenverhältnisse W/L der beiden P-MOSFET T4, T5 sind derart festgelegt, dass an dem Source-Anschluß des zweiten P-MOSFET T5 der Speichersignalstrom $I_{BL}$ um einen festen Verstärkungsfaktor K verstärkt abgegeben wird.

Bei den herkömmlichen Lese-Stromverstärker, wie er in Figur 2 dargestellt ist, gilt für die Ausgangsspannung am Ausgang A:

$$VA \; = \; V_{DD} \qquad wenn \qquad K \; * \; I_{BL} \; \geq \; I_{REF\emptyset} \qquad\qquad (3)$$
$$VA \; = \; \emptyset \qquad\quad wenn \qquad K \; * \; I_{BL} \; < \; I_{REF\emptyset}$$

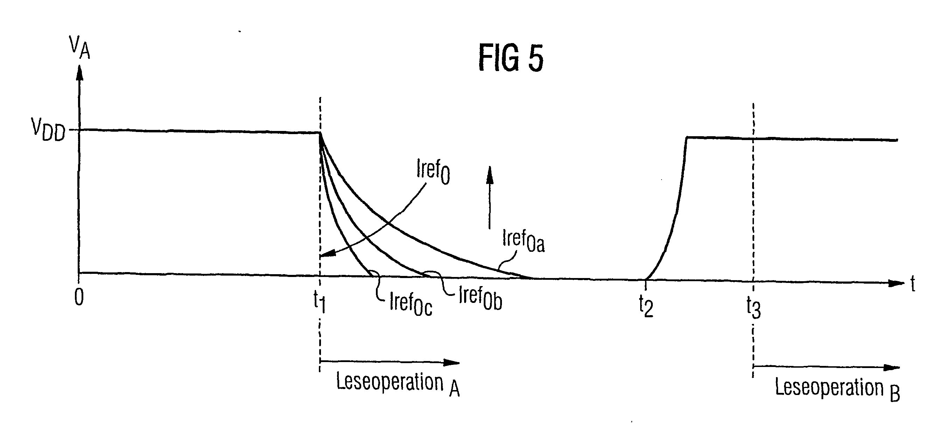

Bei dem herkömmlichen Lese-Stromverstärker nach dem Stand der Technik, wie er in Figur 2 dargestellt ist, besteht ein Nachteil darin, dass nicht gleichzeitig eine hohe Lesegeschwindigkeit zum Auslesen der Speicherzelle SZ und ein niedriger Leistungsverbrauch P des Lese-Stromverstärkers LSV erreichbar ist. Dies wird im weiteren unter Bezugnahme auf den in Figur 5 dargestellten Signalverlauf erläutert. Wird die Speicherzelle SZ nicht ausgelesen, liegt der Ausgang A der Lese-Stromverstärkers LSV auf einem vorgegebenen hohen Potential, das der Versorgungsspannung $V_{DD}$ entspricht. Wenn die Speicherzelle SZ nicht ausgelesen wird, ist der Speichersignalstrom $I_{BL}$ 0.

Zum Zeitpunkt $t_1$ wird bei dem in Figur 5 dargestellten Beispiel eine Lese-Operation A eingeleitet, bei der eine Speicherzelle SZ ausgelesen wird, die sich in einem logisch niedrigen Zustand L befindet. Beim Auslesen einer Speicherzelle SZ, die einen logisch niedrigen Zustand L einnimmt, wird ein Speichersignalstrom $I_{BL}$ von null erzeugt, so dass auch am Ausgang der Stromspiegelschaltung ein Ausgangsstrom von $K*I_{BL}$ abgegeben wird, der niedriger ist als der konstante in die Referenzstromquelle fließende Referenzstrom $I_{REF0}$. Da der aus dem Stromknoten fließende Referenzstrom $I_{REF0}$ größer ist als der in den Stromknoten A fließende verstärkte Speichersignalstrom ($K*I_{BL}$) wird die intrinsische bzw. parasitäre Kapazität $C_A$ am Ausgang A des Lese-Stromverstärkers LSV nach dem Stand der Technik entladen, so dass die Ausgangsspannung $V_A$ am Ausgang A des Lese-Stromverstärkers sinkt, wie in Figur 5 dargestellt ist.

Der Entladevorgang am Ausgang A des Lese-Stromverstärkers LSV erfolgt um so schneller je höher der konstante Referenzstrom $I_{REF0}$ ist. Bei einem relativ niedrigen Referenzstrom $I_{REFO_A}$ dauert der Entladevorgang relativ lange, während bei einem relativ hohen Referenzstrom $I_{REFO_C}$ der Entladevorgang schnell erfolgt.

Für die Entladezeit $\tau$ der intrinsischen Kapazität $C_A$ am Ausgang A des Lese-Stromverstärkers LSV nach dem Stand der Technik gilt daher näherungsweise:

$$\tau \; \cong \; V_{DD}/I_{REF\emptyset}*C_A \qquad\qquad (4)$$

Je schneller der Entladevorgang am Ausgang A des Lese-Stromverstärkers LSV erfolgt, desto höhere Auslesegeschwindigkeiten können über den Halbleiterspeicher erreicht werden.

Zum Zeitpunkt $t_2$ wird die Lese-Operation A beendet und der Ausgangsknoten A des Lese-Stromverstärkers wieder aufgeladen. Zum Zeitpunkt $t_3$ wird eine weitere Lese-Operation B eingeleitet, bei der diesmal die Speicherzelle SZ in einem logisch hohen Zustand H ausgelesen wird. Die Speicherzelle SZ liefert in diesem Zustand einen Speichersignalstrom $I_{BL}$ vorgegebener Größe, der durch die Stromspiegelschaltung verstärkt wird. Da der verstärkte Signalstrom $K*I_{BL}$ größer ist als der konstante Referenzstrom $I_{REF0}$, ist die Ausgangsspannung $V_A$ am Ausgang A des Lese-Stromverstärkers gemäß Gleichung (3) $V_A = V_{DD}$.

Bei dem herkömmlichen Lese-Stromverstärker LSV, wie in Figur 2 dargestellt ist, besteht folgende Problematik. Je höher der konstante Referenzstrom $I_{REF0}$ ist, desto geringer ist die Entladezeit τ und desto geringer sind die möglichen Auslesezeiten des Speichers. Dies führt jedoch dazu, dass gemäß Gleichung (3) die Stromverstärkung K durch die Stromspiegelschaltung ausreichend hoch sein muss, um beim Auslesen einer Speicherzelle SZ, die sich in einem logisch hohen Zustand befindet, die Ungleichungsbedingung zu erfüllen und sicher auf das hohe Spannungspotential $V_{DD}$ am Ausgang A zu schalten. Ein hoher Verstärkungsfaktor K der Stromspiegelschaltung ist jedoch gleichbedeutend mit einer hohen Verlustleistung P des Lese-Stromverstärkers LSV. Die hohe Verlustleistung P bringt einige Nachteile mit sich. Je höher die Verlustleistung P desto höher ist die vom Lese-Stromverstärker LSV erzeugte Temperatur T, so dass unter Umständen Kühleinrichtungen notwendig werden. Darüber hinaus werden breitere Stromversorgungsleitungen bei einem integrierten Lese-Stromverstärker LSV notwendig, um die notwendige Leistung zu erreichen. Ein weiterer Nachteil besteht darin, dass bei batteriebetriebenen Lese-Stromverstärkern LSV die Batterien in kürzeren Zeitabständen wieder aufgeladen werden müssen. Dies hat insbesondere bei tragbaren Geräten, die Halbleiterspeicher enthalten, wie bspw. tragbaren Telefonen, erhebliche Nachteile.

Es ist daher die Aufgabe der vorliegenden Erfindung einen Lese-Stromverstärker zu schaffen, der einerseits eine hohe Geschwindigkeit beim Auslesen eines Halbleiterspeichers ermöglicht und gleichzeitig einen niedrigen Leistungsverbrauch aufweist.

Diese Aufgabe wird erfindungsgemäß durch einen Hochgeschwindigkeits-Lese-Stromverstärker mit niedrigem Leistungs-verbrauch mit den im Patentanspruch 1 angegebenen Merkmalen gelöst.

Die Erfindung schafft einen Hochgeschwindigkeits-Lese-Stromverstärker mit niedrigem Leistungsverbrauch für eine Speicherzelle, wobei der Lese-Stromverstärker aufweist:

eine erste Stromspiegelschaltung, die einen von der Speicherzelle über eine Speichersignalleitung empfangenen Speichersignalstrom verstärkt an einem Signalausgang des Lese-Stromverstärkers abgibt;
eine zweite Stromspiegelschaltung, die einen Einstellstrom in Abhängigkeit des empfangenen Speichersignalstroms erzeugt; und
eine einstellbare Referenzstromquelle, die einen Referenzstrom an den Signalausgang des Lese-Stromverstärkers abgibt, wobei die Höhe des abgegebenen Referenzstroms in Abhängigkeit des durch die zweite Stromspiegelschaltung erzeugten Einstellstroms über eine Einstell-Leitung einstellbar ist.

Die erste und die zweite Stromspiegelschaltung des erfindungsgemäßen Hochgeschwindigkeits-Lese-Stromverstärkers sind vorzugsweise parallel zueinander an die Speichersignalleitung geschaltet.

Dabei sind die beiden Stromspiegelschaltungen vorzugsweise jeweils aus zwei MOSFET aufgebaut, deren Gate-Anschlüsse miteinander verbunden sind.

Bei einer bevorzugten Ausführungsform des erfindungsgemäßen Hochgeschwindigkeits-Lese-Stromverstärkers weist die erste Stromspiegelschaltung einen ersten MOSFET auf, dessen Gate-Anschluß und dessen Source-Anschluß mit der Speichersignalleitung verbunden sind und dessen Drain-Anschluß an einer Versorgungsspannung $V_{DD}$ anliegt, sowie einen zweiten MOSFET, dessen Gate-Anschluß mit dem Gate-Anschluß des ersten MOSFET verbunden ist, dessen Drain-Anschluß an der Versorgungsspannung $V_{DD}$ anliegt und dessen Source-Anschluß an den Signalausgang des Lese-Stromverstärkers angeschlossen ist.

Bei einer bevorzugten Ausführungsform des erfindungsgemäßen Hochgeschwindigkeits-Lese-Stromverstärkers weist die zweite Stromspiegelschaltung einen ersten MOSFET auf, dessen Gate-Anschluß und dessen Source-Anschluß mit der Speichersignalleitung verbunden ist und dessen Drain-Anschluß an einer Versorgungsspannung $V_{DD}$ anliegt, sowie einen zweiten MOSFET, dessen Gate-Anschluß mit dem Gate des ersten MOSFET verbunden ist, dessen Drain-Anschluß an der Versorgungsspannung $V_{DD}$ anliegt und dessen Source-Anschluß an die Einstell-Leitung zur Abgabe des Einstellstromes angeschlossen ist.

Die einstellbare Referenzstromquelle des erfindungsgemäßen Lese-Stromverstärkers weist vorzugsweise eine Stromspiegelschaltung zur einstellbaren Verstärkung eines konstanten Stroms auf, wobei die Stromspiegelschaltung einen ersten MOSFET besitzt, dessen Drain-Anschluß an einem Referenzstromquellenanschluß der Referenzstromquelle zur Abgabe eines verstärkten einstellbaren Referenzstroms mit dem Signalausgang des Speicher-Lese-Stromverstärkers verbunden ist, dessen Source-Anschluß an einem Einstellanschluss der Referenzstromquelle mit der Einstell-Leitung zum Empfangen des Einstellstroms verbunden ist und dessen Gate-Anschluß an einen Gate-Anschluß eines zweiten MOSFETS der Stromspiegelschaltung angeschlossen ist.

Der durch die Referenzstromquelle abgebbare einstellbare Referenzstrom wird vorzugsweise in Abhängigkeit des über dem Einstellanschluss empfangenen Einstellstroms eingestellt.

Dabei wird vorzugsweise durch den empfangenen Einstellstrom die Spannung $V_{GS}$ zwischen dem Gate-Anschluß und dem Source-Anschluß des ersten MOSFETS der Stromspiegelschaltung innerhalb der Referenzstromquelle zur Veränderung des einstellbaren Referenzstroms eingestellt.

Der Ausgang des Lese-Stromverstärkers weist vorzugsweise eine Kapazität auf.

Bei einer besonders bevorzugten Ausführungsform des erfindungsgemäßen Lese-Stromverstärkers weist der Signalausgang einen Signalpufferschaltkreis auf.

Die Speichersignalleitung weist bei einer weiteren bevorzugten Ausführungsform des erfindungsgemäßen Lese-Stromverstärkers einen gesteuerten Multiplexer zum Durchschalten des Speichersignalstroms an die beiden Stromspiegelschaltungen des Lese-Stromverstärkers auf.

Die Speichersignalleitung ist vorzugsweise an einen Ladeschaltkreis zum Aufladen bzw. Wiederaufladen des Speichersignalleitung angeschlossen.

Bei der Speicherzelle handelt es sich um eine RAM-Speicherzelle oder um eine ROM-Speicherzelle.

Im weiteren werden bevorzugte Ausführungsformen des erfindungsgemäßen Hochgeschwindigkeits-Lese-Stromverstärkers unter Bezugnahme auf die beigefügten Figuren zur Erläuterung erfindungswesentlicher Merkmale beschrieben.

Es zeigen:

Figur 1 ein Blockschaltbild einer herkömmlichen Halbleiterspeicheranordnung nach dem Stand der Technik;

Figur 2 ein Schaltkreisdiagramm mit einem Lese-Stromverstärker LSV nach dem Stand der Technik;

Figur 3 eine in dem in Figur 2 dargestellten Lese-Stromverstärker LSV enthaltene Referenzstromquelle nach dem Stand Technik;

Figur 4 eine in dem in Figur 2 dargestellten Lese-Stromverstärker LSV enthaltene Stromspiegelschaltung nach dem Stand der Technik;

Figur 5 ein Signalzeitablaufdiagramm zur Erläuterung der der Erfindung zu Grunde liegenden Problematik;

Figur 6 ein Schaltkreisdiagramm mit einem erfindungsgemäßen Hochgeschwindigkeits-Lese-Stromverstärker;

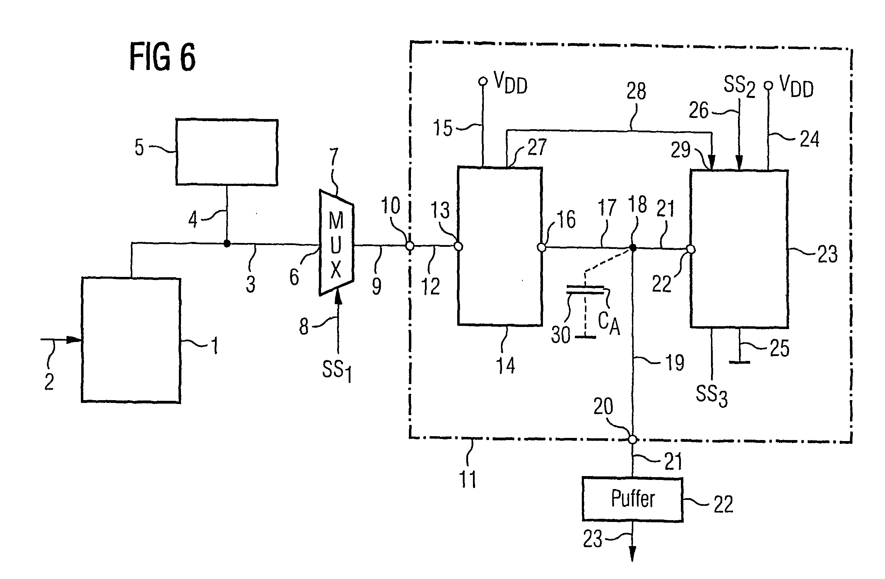

Figur-7 eine in dem in Figur 6 dargestellten erfindungsgemäßen Lese-Stromverstärker enthaltene einstellbare Referenzstromquelle;

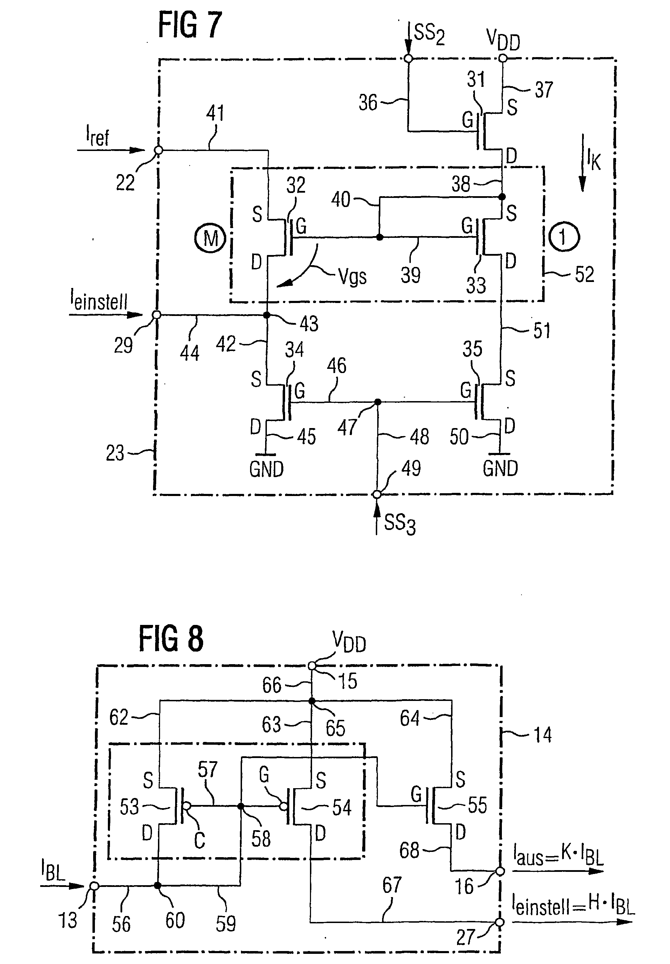

Figur 8 die in dem in Figur 6 dargestellten erfindungsgemäßen Lese-Stromverstärker enthaltenen Stromspiegelschaltungen.

Figur 6 stellt eine Schaltungsanordnung dar, die den erfindungsgemäßen Hochgeschwindigkeits-Lese-Stromverstärker zeigt.

Eine Speicherzelle 1 wird über eine Wortleitung 2 durch einen nicht dargestellten Adressendekoder adressiert und gibt über eine Speichersignalleitung bzw. Bitleitung 3 einen Speichersignalstrom ab. Die Speichersignalleitung 3 ist über eine Leitung 4 an einen Ladeschaltkreis 5 zum Aufladen bzw. Wiederaufladen der Speichersignalleitung 3 angeschlossen. Die Speichersignalleitung 3 liegt an einem Eingang 6 eines Multiplexerschaltkreises 7 an, der über eine Steuerleitung 8 zum Durchschalten der Speichersignalleitung 3 an eine Ausgangsleitung 9 des Multiplexerschaltkreises 7 steuerbar ist.

Die Leitung 9 liegt an einem Signaleingang 10 des erfindungsgemäßen Hochgeschwindigkeits-Lese-Stromverstärkers 11 an. Der Signaleingang 10 des Hochgeschwindigkeits-Lese-Stromverstärkers 11 ist über eine interne Leitung 12 mit einem Signaleingang 13 eines Stromspiegelschaltkreises 14 verbunden. Der Stromspiegelschaltkreis 14 wird über eine Versorgungsspannungsleitung 15 mit einer Versorgungsspannung $V_{DD}$ versorgt. Der Stromspiegelschaltkreis 14 weist einen Stromausgang 16 auf, über den der Stromspiegelschaltkreis 14 den am Signaleingang 13 erhaltenen Speichersignalstrom $I_{BL}$ verstärkt über eine Leitung 17 an einen Stromknoten 18 abgibt. Der Stromknoten 18 ist über eine interne Ausgangsleitung 19 des Lese-Stromverstärkers 11 mit einem Signalausgang 20 des Lese-Stromverstärkers 11 verbunden. Der Stromknoten 18 ist ferner über eine Leitung 21 mit einem Referenzstromquellenanschluß 22 einer einstellbaren Referenzstromquelle 23 verbunden. Die einstellbare Referenzstromquelle 23 ist über eine Versorgungsspannungsleitung 24 an die Versorgungsspannung $V_{DD}$ angeschlossen. Die einstellbare Referenzstromquelle weist ferner eine Erdungsleitung 25 zur Verbindung mit Masse GND auf. Über eine Steuerleitung 26 erhält die einstellbare Referenzstromquelle 23 ein Selektionssignal SS2.

Der Stromspiegelschaltkreis 14 besitzt einen Ausgangsanschluß 27, der über eine Einstellleitung 28 mit einem Stromeinstelleingang 29 der Referenzstromquelle 23 verbunden ist. Über die Einstell-Leitung 28 stellt der Stromspiegelschaltkreis 14 die Höhe des von der Referenzstromquelle 23 am Referenzstromquellenanschluß 22 abgegebenen Referenzstroms $I_{ref}$ ein.

Der Ausgang 20 des Lese-Stromverstärkers 11 ist über eine Ausgangsleitung 21 mit einem Datenpuffer 22 verbunden. Der Datenpuffer 22 besteht vorzugsweise aus einer Reihenschaltung von Invertergattern. Der Datenpuffer 22 besitzt eine Ausgangsleitung 23 zum Anschluß an einen internen Datenbus.

Der mit dem Signalausgang 20 des Lese-Stromverstärkers 11 verbundene Summenstromknoten 18 besitzt eine intrinsische Kapazität 30.

Figur 7 zeigt die in Figur 6 dargestellte einstellbare Referenzstromquelle 23 im Detail. Die einstellbare Referenzstromquelle 23 enthält fünf N-MOSFET 31, 32, 33, 34, 35. Der Gate-Anschluß des MOSFETs 31 wird über eine Leitung 36 durch das Selektionssignal SS2 gesteuert. Der Source-Anschluß des MOSFETs 31 wird über eine Leitung 37 mit der Versorgungsspannung $V_{DD}$ versorgt. Der Drain-Anschluß des MOSFET 31 liegt über eine Leitung 38 an dem Source-Anschluß des MOSFET 33 an. Die beiden Gate-Anschlüsse der MOSFET 32, 33 sind über eine Verbindungsleitung 39 miteinander verbunden. Dabei sind die beiden Leitungen 38, 39 über eine Leitung 40 kurz geschlossen. Der Source-Anschluß des MOSFET 32 wird über eine Leitung 41 an den Referenzstromquellenanschluß 22 angeschlossen. An dem Drain-Anschluß des MOSFET 32 liegt über eine Leitung 42 der Source-Anschluß des MOSFET 34 an. Die Leitung 42, die die beiden MOSFET 32, 34 miteinander verbindet, ist an einem Knoten 43 über eine Leitung 44 an den Einstellanschluss 29 der Referenzstromquelle 23 angeschlossen. Der Drain-Anschluß des MOSFET 34 liegt über eine Leitung 45 an Masse an. Die beiden Gate-Anschlüsse der MOSFET 34, 35 sind über eine Verbindungsleitung 46 miteinander verbunden, die an einem Knoten 47 über eine Leitung 48 an einem Steueranschluß 49 zum Anlegen eines Selektionssignals SS3 angeschlossen ist. Der Drain-Anschluß des MOSFET 35 liegt über eine Erdungsleitung 50 ebenfalls an Masse an. Der Source-Anschluß des MOSFET 35 ist mit dem Drain-Anschluß des MOSFET 33 über eine Leitung 51 verbunden.

Ist das Selektionssignal SS2 logisch hoch, wird der MOSFET 31 durchgeschaltet und erzeugt einen konstanten Strom $I_K$, der durch eine Stromspiegelschaltung gespiegelt wird. Dabei wird die Stromspiegelschaltung 52 der einstellbaren Referenzstromquelle durch die beiden MOSFET 32, 33 gebildet. Der am Referenzstromquellenanschluß 22 aufgenommene Referenzstrom $I_{REF}$ wird in Abhängigkeit des am Einstellanschluss 29 gefangenen Einstellstrom $I_{EINSTELL}$ variabel eingestellt.

Es gilt:

$$I_{REF}(V_{GS32}) \; = \; \frac{\mu \, C_{ox} \, W/L}{2} \; (V_{GS32} \; - \; V_{T32})^2 \tag{5}$$

Der von der Referenzstromquelle 23 abgegebene einstellbare Referenzstrom $I_{REF}$ hängt von der Gate/Source-Spannung am MOSFET 32 ab.

Wenn das Selektionssignal SS3 an ist, nimmt mit zunehmenden Einstellstrom $I_{EINSTELL}$ die Gate/Source-Spannung $V_{GS32}$ an dem MOSFET 32 ab und der erzeugte Referenzstrom $I_{REF}$ am Referenzstromanschluss 22 sinkt.

Es gilt somit:

$$I_{REF} \; = \; I_{REF} \; (I_{EINSTELL}) \tag{6}$$

Das Verstärkungsverhältnis mit dem der Konstantstrom IK verstärkt durch die Stromspiegelschaltung 52 gespiegelt wird, ist durch die Kanalweiten/Längenverhältnis (W/L) der MOSFET-Transistoren 32, 33 festgelegt. Typische Verstärkungsfaktoren M liegen in einem Bereich von 1-10.

Figur 8 zeigt den in Figur 6 dargestellten Stromspiegelschaltkreis 14 gemäß der Erfindung im Detail. Der Stromspiegelschaltkreis 14 erhält über den Signaleingang 13 den von der Speicherzelle 1 abgegebenen Speichersignalstrom und wird über die Spannungsversorgungsleitung 15 mit der Versorgungsspannung $V_{DD}$ versorgt. Der Stromspiegelschaltkreis 14 weist ferner einen Stromausgang 16 zur Abgabe eines verstärkten Speichersignalstroms und einen Einstellausgangsanschluss 27 zur Abgabe eines Einstellstroms $I_{EINSTELL}$ auf. Der Stromspiegelschaltkreis 14 enthält drei P-MOSFETs 53, 54, 55. Der Drain-Anschluß des P-MOSFET 53 ist über eine Leitung 56 mit dem Signaleingang 13 des Stromspiegelschaltkreises 14 verbunden. Die beiden Gate-Anschlüsse der MOSFETs 53, 54 sind über eine Verbindungsleitung 57 miteinander verbunden. An einem Potentialknoten 58 ist die Verbindungsleitung 57 zwischen den beiden P-MOSFET 53, 54 über eine Leitung 59 an einem Verzweigungsknoten 60 mit der Leitung 56 verbunden. Der Knoten 58 ist ferner über eine Leitung 61 mit dem Gate-Anschluß des P-MOSFET 55 verbunden. Die Source-Anschlüsse der P-MOSFET 53, 54, 55 sind über Spannungsversorgungsleitungen 62, 63, 64 an einem Knoten 65 angeschlossen, der über eine Leitung 66 an der Versorgungsspannung $V_{DD}$ anliegt. Der Drain-Anschluß des P-MOSFET 54 ist über eine Leitung 67 mit dem Einstellausgangsanschluss 27 des Stromspiegelschaltkreises 14 verbunden. Der Drain-Anschluß des P-MOSFET 55 liegt über eine Leitung 68 an dem Stromausgangsanschluß 16 des Stromspiegelschaltkreises an.

Der in Figur 8 dargestellte Stromspiegelschaltkreis 14 gemäß der Erfindung enthält eine erste Stromspiegelschaltung, die durch die beiden P-MOSFET 53, 55 gebildet wird, und eine zweite Stromspiegelschaltung, die durch die beiden P-MOSFET 53, 54 gebildet wird. Die erste Stromspiegelschaltung 53, 55 verstärkt den von der Speicherzelle 1 über die Speichersignalleitung 3 abgegebenen Speichersignalstrom $I_{BL}$ mit einem Verstärkungsfaktor K und gibt den verstärkten Speichersignalstrom an dem Stromausgang 16 ab.

Die zweite Stromspiegelschaltung 53, 54 erzeugt einen Einstellstrom $I_{EINSTELL}$ in Abhängigkeit des am Signaleingang 13 empfangenen Speichersignalstroms $I_{BL}$. Hierzu wird der Empfang der Speichersignalstrom mit einer Verstärkung H verstärkt.

Es gilt:

$$I_{EINSTELL} = H \cdot I_{BL} \qquad\qquad (7)$$

Die beiden Verstärkungsfaktoren K, H können durch die Kanalweiten/Längenverhältnisse der P-MOSFET-Transistoren 53, 54, 55 festgelegt werden.

Falls bei einer Speicher-Lese-Operation B der Speichersignalstrom $I_{BL}$ beim Auslesen eines logisch hohen Zustandes in der Speicherzelle 1 hoch ist, ist der Einstellstrom $I_{EINSTELL}$ ebenfalls hoch. Der hohe Einstellstrom $I_{EINSTELL}$ wird über die Einstell-Leitung 28 dem Einstellanschluss 29 der steuerbaren Referenzstromquelle 23 zugeführt, so dass die Gate/Source-Spannung $V_{GS}$ zwischen dem Gate-Anschluß und dem Source-Anschluß des N-MOSFET 32 absinkt. Gemäß Gleichung (5) sinkt somit der einstellbare Referenzstrom $I_{REF}$ mit abnehmender Gate/Source-Spannung ab. Daher ist bei dem erfindungsgemäßen Lese-Stromverstärker 11 bei der Lese-Operation B (wie sie in Figur 5 dargestellt ist) und aufgrund des niedrig eingestellten Referenzstroms $I_{ref}$ die Verlustleistung P gering.

Wird umgekehrt bei der Speicher-Lese-Operation A ein niedriger Signalspeicherstrom $I_{BL}$ aus der Speicherzelle 1 ausgelesen, sinkt der Einstellstrom $I_{EINSTELL}$ gemäß Gleichung (7) ab und die Gate/Source-Spannung am MOSFET 32 innerhalb der steuerbaren Referenzstromquelle 23 steigt an. Gemäß Gleichung (5) steigt hierdurch der eingestellte Referenzstrom $I_{REF}$, der von der steuerbaren Referenzstromquelle 23 abgegeben wird, ebenfalls an. Aufgrund des ansteigenden Referenzstroms $I_{REF}$ nimmt die notwendige Speicher-Auslesezeit mit sinkender Entladezeit $\tau$ gemäß Gleichung (4) erheblich ab. Hierdurch können erheblich höhere Auslesegeschwindigkeiten zum Auslesen des Halbleiterspeichers erreicht werden.

Der erfindungsgemäße Lese-Stromverstärker 11 ermöglicht mindestens eine Verdopplung der Ausslesege-schwindigkeit zum Auslesen der Speicherzelle 1 eines Halbleiterspeichers.

Die Drain- und Sourceanschlüsse (D, S) der in den Figuren 7, 8 dargestellten MOSFETs sind austauschbar.

Der erfindungsgemäße Hochgeschwindigkeits-Lese-Stromverstärker 11 mit niedrigen Leistungsverbrauch für eine Speicherzelle 1 garantiert im Falle der Lese-Operation A (siehe Figur 5), d. h. für einen niedrigen ausgelesenen Speichersignalstrom aufgrund des hohen Referenzstroms $I_{REF}$ eine hohe Umschaltgeschwindigkeit am Ausgang des Lese-Stromverstärkers und im Falle einer Lese-Operation B, d. h. bei einem hohem Speichersignalstrom aufgrund des niedrig eingestellten Referenzstroms $I_{REF}$ einen geringen Leistungsverbrauch P, da der Wert des Referenzstroms an den an den Wert des Speichersignalstromsangepasst wird. Eine Erhöhung der Spiegelverstärkung K ist somit nicht notwendig.

Bezugszeichenliste

1. Speicherzelle
2. Wortleitung
3. Speichersignalleitung
4. Leitung
5. Ladeschaltkreis
6. Multiplexereingang

| | |
|---|---|
| 7 | Multiplexer |
| 8. | Multiplexersteuerleitung |
| 9. | Leitung |
| 10. | Signaleingang |
| 11. | Hochgeschwindigkeits-Lese-Stromverstärker |
| 12. | Leitung |
| 13. | Eingang des Stromspiegelschaltkreises 14 |
| 14. | Stromspiegelschaltkreis |
| 15. | Spannungsversorgungsleitung |
| 16. | Stromausgang der Stromspiegelschaltkreises 14 |
| 17. | Leitung |
| 18. | Stromknoten |
| 19. | Leitung |
| 20. | Signalausgang |
| 21. | Leitung |
| 22. | Pufferschaltkreis |
| 23. | Leitung |
| 24. | Spannungsversorgungsleitung |
| 25. | Erdungsleitung |
| 26. | Steuerleitung |
| 27. | Einstellausgang |
| 28. | Einstell-Leitung |
| 29. | Einstelleingang |
| 30. | parasitäre Kapazität |
| 31. | N-MOSFET |
| 32. | N-MOSFET |
| 33. | N-MOSFET |
| 34. | N-MOSFET |
| 35. | N-MOSFET |
| 36. | Leitung |
| 37. | Leitung |
| 38. | Leitung |
| 39. | Leitung |
| 40. | Leitung |
| 41. | Leitung |
| 42. | Leitung |
| 43. | Knoten |
| 44. | Leitung |
| 45. | Leitung |
| 46. | Leitung |
| 47. | Knoten |
| 48. | Leitung |
| 49. | Steuereingang |
| 50. | Leitung |
| 51. | Leitung |
| 52. | Stromspiegelschaltung |
| 53. | P-MOSFET |
| 54. | P-MOSFET |
| 55. | P-MOSFET |
| 56. | Leitung |
| 57. | Leitung |
| 58. | Knoten |
| 59. | Leitung |
| 60. | Knoten |
| 61. | Leitung |
| 62. | Leitung |
| 63. | Leitung |
| 64. | Leitung |

65. Knoten
66. Leitung
67. Leitung
68. Leitung

**Patentansprüche**

1. Hochgeschwindigkeits-Lese-Stromverstärker mit niedrigem Leistungsverbrauch für eine Speicherzelle (1), wobei der Lese-Stromverstärker aufweist:

   eine erste Stromspiegelschaltung (14; 53, 55), die einen von der Speicherzelle (1) über eine Speichersignalleitung (3) empfangenen Speichersignalstrom ($I_{BL}$) verstärkt an einem Signalausgang (16) des Lese-Stromverstärkers (11) abgibt;
   eine Referenzstromquelle (23), die einen Referenzstrom ($I_{REF}$) an den Signalausgang (20) des Lese-Stromverstärkers (11) abgibt, **gekennzeichnet durch** eine zweite Stromspiegelschaltung (14; 53, 54), die einen Einstellstrom ($I_{EINSTELL}$) in Abhängigkeit von dem empfangenen Speichersignalstrom ($I_{BL}$) erzeugt; und wobei die Höhe des des von der Referenz stromquelle (23) abgegebenen Referenzstroms ($I_{REF}$) in Abhängigkeit des **durch** die zweite Stromspiegelschaltung (53, 54) erzeugten Einstellstroms ($I_{E^-INSTFLL}$) über eine Einstell-Leitung (28) eingestellt wird.

2. Hochgeschwindigkeits-Lese-Stromverstärker nach Anspruch 1
   **dadurch gekennzeichnet,**
   **dass** die erste Stromspiegelschaltung (53, 55) und die zweite Stromspiegelschaltung (53, 54) zueinander parallel an die Speichersignalleitung (3) geschaltet sind.

3. Hochgeschwindigkeits-Lese-Stromverstärker nach Anspruch 1 oder 2
   **dadurch gekennzeichnet,**
   **dass** die beiden Stromspiegelschaltungen (53, 55; 53, 54) jeweils aus zwei MOSFETS bestehen, deren Gate-Anschlüsse miteinander verbunden sind.

4. Hochgeschwindigkeits-Lese-Stromverstärker nach einem der vorangehenden Ansprüche
   **dadurch gekennzeichnet,**
   **dass** die erste Stromspiegelschaltung (53, 55) einen ersten MOSFET (53) aufweist, dessen Gate-Anschluß und dessen Source-Anschluß mit der Speichersignalleitung (3) verbunden ist und dessen Drain-Anschluß an einer Versorgungsspannung ($V_{DD}$) anliegt, und
   einen zweiten MOSFET (55) aufweist, dessen Gate-Anschluß mit dem Gate-Anschluß des ersten MOSFET(53) verbunden ist, dessen Drain-Anschluß an der Versorgungsspannung($V_{DD}$) anliegt, und dessen Source-Anschluß an den Signalausgang (20) des Lese-Stromverstärkers (11) angeschlossen ist.

5. Hochgeschwindigkeits-Lese-Stromverstärker nach einem der vorangehenden Ansprüche
   **dadurch gekennzeichnet,**
   **dass** die zweite Stromspiegelschaltung (53, 54)
   einen ersten MOSFET (53) aufweist, dessen Gate-Anschluß und dessen Source-Anschluß mit der Speichersignalleitung (3) verbunden ist und dessen Drain-Anschluß an einer Versorgungsspannung ($V_{DD}$) anliegt, und
   einen zweiten MOSFET (54) aufweist, dessen Gate-Anschluß mit dem Gate-Anschluß des ersten MOSFET (53) verbunden ist, dessen Drain-Anschluß an der Versorgungsspannung ($V_{DD}$) anliegt und dessen Source-Anschluß an die Einstell-Leitung (28) zur Abgabe des Einstellstrom ($I_{EINSTELL}$) angeschlossen ist.

6. Hochgeschwindigkeits-Lese-Stromverstärker nach einem der vorangehenden Ansprüche
   **dadurch gekennzeichnet,**
   **dass** die einstellbare Referenzstromquelle (23) eine Stromspiegelschaltung (52) zur einstellbaren Verstärkung eines konstanten Stromes ($I_K$) aufweist, wobei die Stromspiegelschaltung (52) einen ersten MOSFET (32) aufweist, dessen Drain-Anschluß an einem Referenzstromquellenanschluß (22) der Referenzstromquelle (23) zur Abgabe eines verstärkten einstellbaren Referenzstroms ($I_{REF}$) mit dem Signalausgang (20) des Lese-Stromverstärkers (11) verbunden ist, dessen Source-Anschluß an einem Einstellanschluss (29) der Referenzstromquelle (23) mit der Einstell-Leitung (28) zum Empfang des Einstellstroms ($I_{EINSTELL}$) verbunden ist und dessen Gate-Anschluß an einen Gate-Anschluß eines zweiten MOSFETS (33) der Stromspiegelschaltung (52) angeschlossen ist.

**7.** Hochgeschwindigkeits-Lese-Stromverstärker nach einem der vorangehenden Ansprüche
**dadurch gekennzeichnet,**
**dass** der durch die Referenzstromquelle (23) abgebbare einstellbare Referenzstrom (IREF) in Abhängigkeit des über den Einstellanschluss (29) empfangenen Einstellstroms ($I_{EINSTELL}$) eingestellt wird.

**8.** Hochgeschwindigkeits-Lese-Stromverstärker nach einem der vorangehenden Ansprüche
**dadurch gekennzeichnet,**
**dass** durch den empfangenen Einstellstrom ($I_{EINSTELL}$) die Spannung $V_{GS}$ zwischen dem Gate-Anschluß und dem Source-Anschluß des ersten MOSFETS (32) der Stromspiegelschaltung (52) innerhalb der Referenzstromquelle (23) zur Verstärkung der Referenzstroms ($I_{REF}$) eingestellt wird.

**9.** Hochgeschwindigkeits-Lese-Stromverstärker nach einem der vorangehenden Ansprüche
**dadurch gekennzeichnet,**
**dass** der Signalausgang (20) des Hochgeschwindigkeits-Lese-Stromverstärkers (11) eine Kapazität (30) aufweist.

**10.** Hochgeschwindigkeits-Lese-Stromverstärker nach einem der vorangehenden Ansprüche
**dadurch gekennzeichnet,**
**dass** der Signalausgang (20) des Hochgeschwindigkeits-Lese-Stromverstärkers (11) einen Signalpufferschaltkreis (22) aufweist.

**11.** Hochgeschwindigkeits-Lese-Stromverstärker nach einem der vorangehenden Ansprüche
**dadurch gekennzeichnet,**
**dass** die Speichersignalleitung einen gesteuerten Multiplexer (7) zum Durchschalten des Speichersignalstroms an die beiden Stromspiegelschaltungen (53, 55; 53, 54) des Hochgeschwindigkeits-Lese-Stromverstärkers (11) aufweist.

**12.** Hochgeschwindigkeits-Lese-Stromverstärker nach einem der vorangehenden Ansprüche
**dadurch gekennzeichnet,**
**dass** an der Speichersignalleitung (3) ein Ladeschaltkreis (5) zum Aufladen bzw. Wiederaufladen der Speichersignalleitung (3) vorgesehen ist.

**13.** Hochgeschwindigkeits-Lese-Stromverstärker nach einem der vorangehenden Ansprüche
**dadurch gekennzeichnet,**
**dass** die Speicherzelle (1) eine RAM-Speicherzelle ist.

**14.** Hochgeschwindigkeits-Lese-Stromverstärker nach einem der vorangehenden Ansprüche 1-12,
**dadurch gekennzeichnet,**
**dass** die Speicherzelle (1) eine ROM-Speicherzelle ist.

**Claims**

**1.** High-speed sense current amplifier with a low power consumption for a memory cell (1), the sense current amplifier having:

a first current mirror circuit (14; 53, 55), which amplifies a memory signal current ($I_{BL}$) received from the memory cell (1) via a memory signal line (3) and outputs it at a signal output (16) of the sense current amplifier (11); a reference current source (23), which outputs a reference current ($I_{REF}$) to the signal output (20) of the sense current amplifier (11), **characterized by** a second current mirror circuit (14; 53, 54), which generates a setting current ($I_{SETTING}$) in a manner dependent on the received memory signal current ($I_{BL}$); and the magnitude of the output reference current ($I_{REF}$) output by the reference current source (23) being set, via a setting line (28), in a manner dependent on the setting current ($I_{SETTING}$) generated by the second current mirror circuit (53, 54).

**2.** High-speed sense current amplifier according to claim 1,
**characterized in that** the first current mirror circuit (53, 55) and the second current mirror circuit (53, 54) are connected to the memory signal line (3) in parallel with one another.

**3.** High-speed sense current amplifier according to claim 1 or 2,

characterized in that the two current mirror circuits (53, 55; 53, 54) each comprise two MOSFETS whose gate terminals are connected to one another.

4. High-speed sense current amplifier according to one of the preceding claims,
characterized in that the first current mirror circuit (53, 55) has a first MOSFET (53) whose gate terminal and whose source terminal are connected to the memory signal line (3) and whose drain terminal is connected to a supply voltage ($V_{DD}$), and
has a second MOSFET (55), whose gate terminal is connected to the gate terminal of the first MOSFET (53), whose drain terminal is connected to the supply voltage ($V_{DD}$) and whose source terminal is connected to the signal output (20) of the sense current amplifier (11).

5. High-speed sense current amplifier according to one of the preceding claims,
characterized in that the second current mirror circuit (53, 54)
has a first MOSFET (53), whose gate terminal and whose source terminal are connected to the memory signal line (3) and whose drain terminal is connected to a supply voltage ($V_{DD}$), and
has a second MOSFET (54), whose gate terminal is connected to the gate terminal of the first MOSFET (53), whose drain terminal is connected to the supply voltage ($V_{DD}$) and whose source terminal is connected to the setting line (28) for outputting the setting current ($I_{SETTING}$).

6. High-speed sense current amplifier according to one of the preceding claims,
characterized in that the adjustable reference current source (23) has a current mirror circuit (52) for the adjustable amplification of a constant current ($I_K$), the current mirror circuit (52) having a first MOSFET (32), whose drain terminal is connected, at a reference current source terminal (22) of the reference current source (23) for outputting an amplified adjustable reference current ($I_{REF}$), to the signal output (20) of the sense current amplifier (11), whose source terminal is connected, at a setting terminal (29) of the reference current source (23), to the setting line (28) for receiving the setting current ($I_{SETTING}$), and whose gate terminal is connected to a gate terminal of a second MOSFET (33) of the current mirror circuit (52).

7. High-speed sense current amplifier according to one of the preceding claims,
characterized
in that the adjustable reference current (IREF) which can be output by the reference current source (23) is set in a manner dependent on the setting current ($I_{SETTING}$) received via the setting terminal (29).

8. High-speed sense current amplifier according to one of the preceding claims,
characterized
in that the received setting current ($I_{SETTING}$) is used to set the voltage $V_{GS}$ between the gate terminal and the source terminal of the first MOSFET (32) of the current mirror circuit (52) within the reference current source (23) for amplifying the reference current ($I_{REF}$).

9. High-speed sense current amplifier according to one of the preceding claims,
characterized
in that the signal output (20) of the high-speed sense current amplifier (11) has a capacitance (30).

10. High-speed sense current amplifier according to one of the preceding claims,
characterized
in that the signal output (20) of the high-speed sense current amplifier (11) has a signal buffer circuit (22).

11. High-speed sense current amplifier according to one of the preceding claims,
characterized
in that the memory signal line has a controlled multiplexer (7) for switching the memory signal current through to the two current mirror circuits (53, 55; 53, 54) of the high-speed sense current amplifier (11).

12. High-speed sense current amplifier according to one of the preceding claims,
characterized
in that a charging circuit (5) for charging or recharging the memory signal line (3) is provided on the memory signal line (3).

13. High-speed sense current amplifier according to one of the preceding claims,

**EP 1 307 885 B1**

**characterized**
**in that** the memory cell (1) is a RAM memory cell.

14. High-speed sense current amplifier according to one of the preceding claims,
**characterized**
**in that** the memory cell (1) is a ROM memory cell.

**Revendications**

1. Amplificateur de courant de lecture à grande vitesse avec petite consommation de courant pour une cellule de mémoire (1), dans lequel l'amplificateur de courant de lecture comporte :

   un premier circuit miroir de courant (14 ; 53, 55) qui délivre le courant de signal de mémoire ($I_{BL}$) reçu de la cellule de mémoire (1) par l'intermédiaire d'une ligne de signal de mémoire (3), sous une forme amplifiée, à une sortie de signal (16) de l'amplificateur de courant de lecture (11) ; et
   une source de courant de référence (23) qui délivre un courant de référence ($I_{REF}$) à la sortie de signal (20) de l'amplificateur de courant de lecture (11) ;

   **caractérisé par** un deuxième circuit miroir de courant (14 ; 53, 54) qui produit un courant de réglage ($I_{EINSTELL}$) en fonction du courant de signal de mémoire ($I_{BL}$) reçu, la hauteur du courant de référence ($I_{REF}$) délivré par la source de courant de référence (23) étant réglée par l'intermédiaire d'une ligne de réglage (28) en fonction du courant de réglage ($I_{EINSTELL}$) produit par le deuxième circuit miroir de courant (53, 54).

2. Amplificateur de courant de lecture à grande vitesse selon la revendication 1,
   **caractérisé en ce que** le premier circuit miroir de courant (53, 55) et le deuxième circuit miroir de courant (53, 54) sont branchés en parallèle l'un avec l'autre sur la ligne de signal de mémoire (3).

3. Amplificateur de courant de lecture à grande vitesse selon la revendication 1 ou 2,
   **caractérisé en ce que** les deux circuits miroirs de courant (53, 55 ; 53, 54) sont constitués chacun de deux MOSFET dont les bornes de grilles sont reliées entre elles.

4. Amplificateur de courant de lecture à grande vitesse selon l'une des revendications précédentes,
   **caractérisé en ce que** le premier circuit miroir de courant (53, 55) comporte un premier MOSFET (53) dont la borne de grille et la borne de source sont reliées à la ligne de signal de mémoire (3) et dont la borne de drain est à une tension d'alimentation ($V_{DD}$), et
   un deuxième MOSFET (55) dont la borne de grille est reliée à la borne de grille du premier MOSFET (53), dont la borne de drain est à la tension d'alimentation ($V_{DD}$) et dont la borne de source est raccordée à la sortie de signal (20) de l'amplificateur de courant de lecture (11).

5. Amplificateur de courant de lecture à grande vitesse selon l'une des revendications précédentes,
   **caractérisé en ce que** le deuxième circuit miroir de courant (53, 54) comporte
   un premier MOSFET (53) dont la borne de grille et la borne de source sont reliées à la ligne de signal de mémoire (3) et dont la borne de drain est à une tension d'alimentation ($V_{DD}$), et
   un deuxième MOSFET (54) dont la borne de grille est reliée à la borne de grille du premier MOSFET (53), dont la borne de drain est à la tension d'alimentation ($V_{DD}$) et dont la borne de source est raccordée à la ligne de réglage (28) pour la délivrance du courant de réglage ($I_{EINSTELL}$).

6. Amplificateur de courant de lecture à grande vitesse selon l'une des revendications précédentes,
   **caractérisé en ce que** la source de courant de référence réglable (23) comporte un circuit miroir de courant (52) pour l'amplification réglable d'un courant constant ($I_K$), le circuit de miroir de courant (52) comportant un premier MOSFET (32) dont la borne de drain est reliée par une borne de source de courant de référence (22) de la source de courant de référence (23) pour la délivrance d'un courant de référence réglable amplifié ($I_{REF}$) à la sortie de signal (20) de l'amplificateur de courant de lecture (11), dont la borne de source est reliée par une borne de réglage (29) de la source de courant de référence (23) à la ligne de réglage (28) pour la réception du courant de réglage ($I_{EINSTELL}$) et dont la borne de grille est raccordée à une borne de grille d'un deuxième MOSFET (33) du circuit miroir de courant (52).

12

**7.** Amplificateur de courant de lecture à grande vitesse selon l'une des revendications précédentes, **caractérisé en ce que** le courant de référence réglable ($I_{REF}$) pouvant être délivré par la source de courant de référence (23) est réglé en fonction du courant de réglage ($I_{EINSTELL}$) reçu par l'intermédiaire de la borne de réglage (29).

**8.** Amplificateur de courant de lecture à grande vitesse selon l'une des revendications précédentes, **caractérisé en ce que** la tension $V_{GS}$ entre la borne de grille et la borne de source du premier MOSFET (32) du circuit miroir de courant (52) à l'intérieur de la source de courant de référence (23) pour l'amplification du courant de référence ($I_{REF}$) est réglée par le courant de réglage reçu ($I_{EINSTELL}$).

**9.** Amplificateur de courant de lecture à grande vitesse selon l'une des revendications précédentes, **caractérisé en ce que** la sortie de signal (20) de l'amplificateur de courant de lecture à grande vitesse (11) comporte une capacité (30).

**10.** Amplificateur de courant de lecture à grande vitesse selon l'une des revendications précédentes, **caractérisé en ce que** la sortie de signal (20) de l'amplificateur de courant de lecture à grande vitesse (11) comporte un circuit de mémorisation temporaire de signal (22).

**11.** Amplificateur de courant de lecture à grande vitesse selon l'une des revendications précédentes, **caractérisé en ce que** la ligne de signal de mémoire comporte un multiplexeur commandé (7) pour la connexion du courant de signal de mémoire aux deux circuits miroirs de courant (53, 55 ; 53, 54) de l'amplificateur de courant de lecture à grande vitesse (11).

**12.** Amplificateur de courant de lecture à grande vitesse selon l'une des revendications précédentes, **caractérisé en ce qu'**il est prévu sur la ligne de signal de mémoire (3) un circuit de charge (5) pour charger ou recharger la ligne de signal de mémoire (3).

**13.** Amplificateur de courant de lecture à grande vitesse selon l'une des revendications précédentes, **caractérisé en ce que** la cellule de mémoire (1) est une cellule de mémoire RAM.

**14.** Amplificateur de courant de lecture à grande vitesse selon l'une des revendications 1 à 12, **caractérisé en ce que** la cellule de mémoire (1) est une cellule de mémoire ROM.

# FIG 1

Stand der Technik

AB     D

Adressbus

Dekoder

Speicher

57   57

57   57

MUX

Leseverstärker

Puffer    P

Datenbus

DB

# FIG 2
Stand der Technik

Ladeschaltkreis

BL

$I_{BL}$

WL

Speicherzelle
L / H

SZ

MUX

SS$_1$

E

$V_{DD}$

Stromspiegel
schaltung

$K \cdot I_{BL}$

$C_A$

$Iref_0$

SS$_2$

$V_{DD}$

Referenzstromquelle

REF

GND

Lese-Stromverstärker
LSV

A

Puffer

EP 1 307 885 B1

# FIG 3
Stand der Technik

Referenzstromquelle

$SS_2$    $V_{DD}$

T1

$I_K$

$Iref_0$

REF

T2    T3

Vgs

# FIG 4
Stand der Technik

$V_{DD}$    $V_{DD}$

T4    T5

$I_{BL}$    $K \cdot I_{BL}$

E

Stromspiegelschaltung

FIG 5

FIG 6

EP 1 307 885 B1

EP 1 307 885 B1

**FIG 7**

**FIG 8**

19